# DEMANDE DE BREVET EUROPEEN

(11) **EP 4 391 019 A1**
(43) Date de publication de la demande: **26.06.2024**
(21) Numéro de dépôt: 23218369.9
(22) Date de dépôt: 19.12.2023
(51) Int. Cl.: H01L 21/02, H01L 21/265, H01L 29/417

(54) **PROCÉDÉ AMÉLIORÉ DE RÉALISATION DE SOURCE ET DRAIN DE TRANSISTORS DOPÉS**

(30) Priorité: 20.12.2022 FR 2213950
(71) Demandeur: Commissariat à l'énergie atomique et aux énergies alternatives, 75015 Paris (FR)
(72) Inventeur: REBOH, Shay, 38054 GRENOBLE CEDEX 09 (FR); ACOSTA ALBA, Pablo, 38054 GRENOBLE CEDEX 09 (FR); MILESI, Frédéric, 38054 GRENOBLE CEDEX 09 (FR)
(74) Mandataire: Brevalex

(57) **Abrégé**

Procédé de réalisation d'un transistor comprenant :
- prévoir sur un support (100, 100') doté d'une couche semi-conductrice superficielle (12) et reposant sur une couche isolante (11) : un bloc de grille (25), des espaceurs isolants (33) de part et d'autre de ce bloc (25) de grille, et des régions semi-conductrices (42) dites surélevées,
- rendre amorphe les régions semi-conductrices (42) surélevées et des portions (12a) de la couche semi-conductrice superficielle (12) situées sous ces régions semi-conductrices (42) surélevées et atteignant la couche isolante (11),
- doper les régions semi-conductrices (42) surélevées et lesdites portions (12a),
- effectuer un recuit thermique laser au moyen d'une ou plusieurs impulsions laser (L) de sorte à réaliser une recristallisation desdites régions surélevées (42) et desdites portions (12a) tout en effectuant une activation de dopants dans lesdites régions et lesdites portions

## Description

### DOMAINE TECHNIQUE ET ÉTAT DE LA TECHNIQUE ANTÉRIEURE

La présente demande concerne le domaine des procédés de fabrication de transistors, et plus particulièrement celui de la formation de régions semi-conductrices de source et de drain dopage amélioré.

Dans les procédés de fabrication de transistors, le dopage des régions de source et de drain pose certaines difficultés. Tout d'abord l'activation des dopants nécessite généralement une température élevée.

En outre, on cherche généralement à prolonger les régions dopées en réalisant un dopage sous des espaceurs isolants afin de créer des zones dites « d'extension » de la source et du drain.

En ce qui concerne le problème de budget thermique, une solution consiste à activer les dopants à basse température pendant une étape de recristallisation épitaxiale en phase solide (SPER pour « Solid Phase Epitaxial Regrowth ») de zones semi-conductrices rendues amorphes et contenant des dopants. La technique SPER favorise la recristallisation d'un solide avec une barrière thermique réduite. Cette technique nécessite la présence d'une épaisseur cristalline servant de germe à la recristallisation.

Avec une telle technique, du silicium amorphe (a-Si) peut par exemple croître en un cristal à partir germes cristallins à des températures basses, par exemple de l'ordre de 500°C. Cette température de SPER peut même être encore réduite avec la présence de dopants.

Ainsi, un procédé pour réaliser des régions de source et de drain dopées consiste à rendre amorphe des zones supérieures de régions semi-conductrices et à conserver une partie cristalline sous-jacente pour pouvoir déclencher la recristallisation SPER. Des dopants sont alors implantés au moins dans la région amorphe. Au cours du procédé de recristallisation, une activation des dopants est mise en oeuvre.

Un inconvénient de cette méthode est que l'on conserve une partie cristalline sous-jacente non dopée, ce qui peut induire une résistance de contact entre le canal et les régions de source drain d'autant plus pénalisante que les épaisseurs mises en jeu sont faibles.

Un autre inconvénient d'une telle méthode, est que pour les couches semi-conductrices très minces, par exemple inférieures à 10 nm, il s'avère difficile de rendre amorphe la partie supérieure de ces couches tout en gardant dans la portion inférieure un germe cristallin d'épaisseur suffisante.

Par ailleurs, la partie cristalline inférieure conservée n'est généralement pas uniforme en termes d'épaisseur, ce qui peut conduire à des variations de résistance, en particulier de résistances d'accès importantes d'un transistor à l'autre sur toute la surface du support sur lequel ces transistors sont réalisés.

Il se pose le problème de trouver un nouveau procédé de fabrication de transistors amélioré vis-à-vis d'inconvénients énoncés ci-dessus.

### EXPOSÉ DE L'INVENTION

Un but de l'invention est de proposer un procédé de réalisation d'un dispositif microélectronique pour la réalisation d'au moins un transistor doté(s) de régions de source et de drain au dopage amélioré, en particulier sur toute leur épaisseur, tout en limitant le budget thermique utilisé.

Un mode de réalisation de la présente invention prévoit un procédé pour la réalisation d'un transistor comprenant les étapes suivantes :
- prévoir sur un support doté d'une couche semi-conductrice superficielle et reposant sur une couche isolante : au moins un bloc de grille de transistor agencé sur la couche superficielle, des espaceurs isolants de part et d'autre de ce bloc de grille, et des régions semi-conductrices dites surélevées reposant sur la couche semi-conductrice superficielle de part et d'autre de ce bloc de grille et des espaceurs isolants, puis,
- rendre amorphe les régions semi-conductrices surélevées et des portions de la couche semi-conductrice superficielle situées sous ces régions semi-conductrices surélevées sur toute leur épaisseur et de sorte à atteindre la couche isolante,
- doper les régions semi-conductrices surélevées et les portions de la couche semi-conductrice superficielle,
   puis,
- effectuer au moins un recuit thermique laser au moyen d'une ou plusieurs impulsions laser de sorte à réaliser une recristallisation des régions surélevées et des portions de la couche semi-conductrice superficielle tout en effectuant une activation de dopants dans ces régions et ces portions.

On réalise ici une amorphisation complète sur toute l'épaisseur des régions semi-conductrices et portions de la couche semi-conductrice superficielle afin de pouvoir effectuer un dopage sur toute l'épaisseur des régions semi-conductrices et portions de la couche semi-conductrice superficielle. Le dopage et l'amorphisation peuvent être réalisés de manière concomitante par implantation.

Le recuit laser a pour avantage de permettre une activation de dopants sans avoir nécessairement préservé préalablement une épaisseur cristalline et tout en limiter le budget thermique utilisé.

On utilise en particulier un recuit laser nano-seconde avec un ou plusieurs impulsions de durée inférieure à 1 µs.

Le recuit thermique laser peut être ainsi est effectuée à l'aide d'un laser de longueur d'onde comprise entre 200 nm et 600 nm et avantageusement entre 200 et 400, par émission d'une ou de plusieurs impulsions laser successives, de durée d'impulsion inférieure à une microseconde et de préférence comprise entre 1 ns et 1000 ns, avantageusement entre 20 ns et 300 ns.

Le recuit thermique laser est de préférence effectué dans un régime dit « explosif » de recristallisation dans lequel les régions semi-conductrices surélevées et les portions sont transformées en matériau polycristallin.

L'homme du métier aurait tendance à vouloir réaliser des régions semi-conductrices de source et de drain en monocristal mais les inventeurs ont constaté expérimentalement, de manière surprenante, que des régions semi-conductrices surélevées et des portions recristallisées selon un tel régime permettent de réaliser des source et de drain ayant une faible résistance.

Selon un mode de réalisation, l'étape consistant à rendre amorphe les régions semi-conductrices surélevées et les portions peut être effectuée par implantation ionique à l'aide d'un faisceau d'ions incliné par rapport à une normale à un plan principal du support, de sorte à réaliser une amorphisation de zones de la couche superficielle qui s'étendent sous les espaceurs. Cela participe à un dopage amélioré des zones d'extension sous les espaceurs.

Avantageusement, le procédé peut comprendre en outre des étapes de :
- formation du bloc de grille,
- formation d'espaceurs de part et d'autre du bloc de grille,
- formation des régions semi-conductrices surélevées de part et d'autre des espaceurs.

Le procédé peut alors comprendre en outre après formation du bloc de grille et préalablement à la formation des espaceurs :
- le dopage de zones dites d'extension de la couche semi-conductrice superficielle situées de part et d'autre du bloc de grille, les espaceurs étant formés en regard des zones d'extension.

Avantageusement, le dopage des zones d'extension dans la couche semi-conductrice superficielle de part et d'autre du bloc de grille comprend des étapes consistant à :
- rendre amorphe et doper une partie supérieure de la couche superficielle tout en conservant une zone inférieure cristalline de la couche superficielle en contact avec la couche isolante,
- effectuer un recuit de sorte à recristalliser la partie supérieure de la couche superficielle.

Selon une possibilité de mise en oeuvre, après formation des espaceurs isolants et préalablement à l'amorphisation des régions semi-conductrices surélevées et portions de la couche semi-conductrice superficielle situées sous ces régions semi-conductrices :
- former par épitaxie les régions semi-conductrices surélevées sur la partie supérieure recristallisée de la couche superficielle.

Selon une mise en oeuvre avantageuse, après le recuit thermique laser, le procédé peut comprendre une étape de formation de régions à base de composé de matériau métallique et de matériau semi-conducteur dans les régions semi-conductrices surélevées.

Selon une première possibilité, préalablement au recuit thermique laser on peut déposer au moins une couche de matériau métallique de sorte à recouvrir les régions semi-conductrices surélevées, le recuit thermique laser étant alors adapté pour former les régions à base de composé de matériau métallique et de matériau semi-conducteur dans les régions semi-conductrices surélevées.

Selon une deuxième possibilité, après le recuit thermique laser, le procédé peut comprendre des étapes consistant à :
- rendre amorphe des parties supérieures des régions semi-conductrices surélevées, puis
- déposer au moins une couche de matériau métallique de sorte à recouvrir les régions semi-conductrices surélevées, et effectuer un recuit pour former des régions à base de composé de matériau métallique et de matériau semi-conducteur dans les parties supérieures.

Selon une mise en oeuvre particulière du procédé, lesdites portions de la couche semi-conductrice superficielle situées sous les régions semi-conductrices surélevées correspondent à des parties de la couche semi-conductrice superficielle non recouvertes par les espaceurs et le bloc de grille et qui s'étendant sur toute l'épaisseur de la couche semi-conductrice superficielle.

Selon une possibilité de mise en oeuvre du procédé, l'étape consistant à rendre amorphe les régions semi-conductrices surélevées et les portions de la couche semi-conductrice superficielle étant effectuée de sorte à ne conserver aucun germe cristallin dans la couche superficielle en dehors d'une zone en regard du bloc de grille.

Le support de la couche superficielle semi-conductrice peut être un substrat de type semi-conducteur sur isolant tel qu'un substrat SOI (pour « Silicon On Insulator » ou « Silicium sur isolant ») ou un support doté d'un ou plusieurs composants d'un premier niveau de composants formés dans une couche semi-conductrice sous-jacente.

Ainsi, le procédé se prête tout particulièrement à la réalisation de dispositifs ou circuits 3D dotés de plusieurs couches semi-conductrices superposées et de plusieurs niveaux de composants réalisés dans ces couches. En particulier, le fait de pouvoir utiliser un budget thermique réduit pour former des régions de source et de drain surélevées le rend particulièrement compatible à la mise en oeuvre de circuits ou dispositifs 3D, c'est-à-dire réalisés sur plusieurs niveaux de composants formés dans des couches semi-conductrices distinctes.

### BRÈVE DESCRIPTION DES DESSINS

La présente invention sera mieux comprise sur la base de la description qui va suivre et des dessins en annexe sur lesquels :
Les figures 1A à 1E illustrent un procédé de réalisation d'un transistor avec des régions semi-conductrices de source et de drain dopées sur toute leur épaisseur.
La figure 2 illustre une variante de réalisation dans laquelle on forme en outre des régions d'alliage de métal et de semi-conducteur dans les régions semi-conductrices dopées.
La figure 3 illustre une variante de réalisation dans laquelle un recuit laser est effectué après le dopage des régions semi-conductrices puis une étape de dépôt de matériau métallique afin de mutualiser une activation de dopants avec une siliciuration des régions semi-conductrices de source et de drain ;
Les figures 4A à 4F illustrent un autre exemple de réalisation particulier pour lequel on réalise un dopage de zones d'extensions avant de former et doper les parties surélevées de régions de source et drain.
Les figures 5A à 5I illustrent un autre exemple de réalisation particulier pour lequel on réalise un dopage de zones d'une couche semi-conductrice superficielle avant de former des parties surélevées des régions de source et drain et de rendre amorphe sur toute leur épaisseur ces zones et ces parties surélevées.
La figure 6 illustre un exemple de réalisation particulier dans lequel le support à partir duquel on réalise le procédé est déjà doté d'un niveau de composants formés dans une couche semi-conductrice sous-jacente.

En outre, dans la description ci-après, des termes qui dépendent de l'orientation d'une structure tels que « avant », « supérieure », « arrière », « inférieure », « latérale », s'appliquent en considérant que la structure est orientée de la façon illustrée sur les figures.

### EXPOSÉ DÉTAILLÉ DE MODES DE RÉALISATION PARTICULIERS

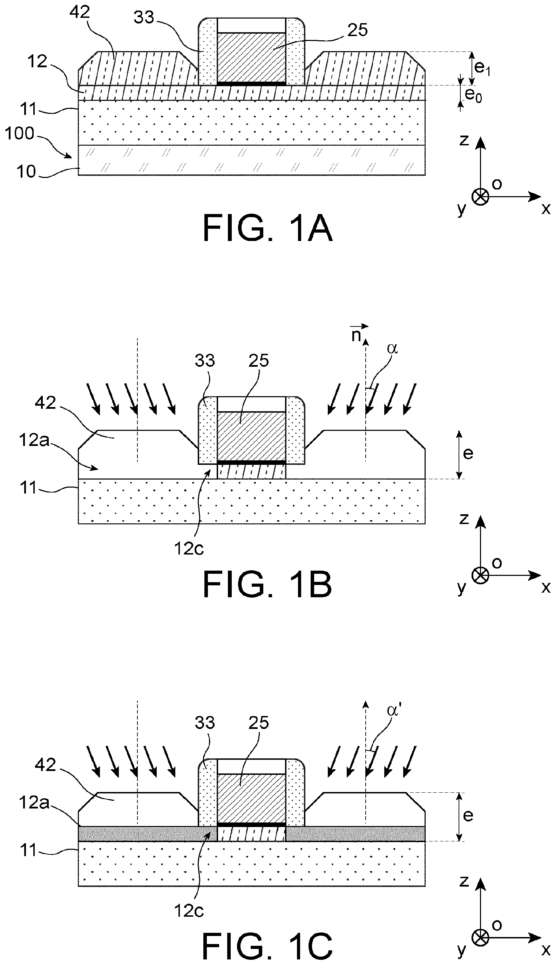

Une structure de départ possible pour la réalisation d'un procédé suivant l'invention et mis en oeuvre pour la fabrication d'au moins un transistor est donnée sur la figure 1A.

Cette structure comprend un support 100 doté d'une couche isolante 11, par exemple en SiO₂, et communément appelée de BOX (« buried-oxide » ou oxyde enterré), la couche isolante 11 étant elle-même revêtue d'une couche semi-conductrice 12 superficielle dans laquelle un ou plusieurs transistors sont destinés à être formés.

La couche semi-conductrice 12 superficielle, par exemple en silicium, est prévue avec une épaisseur qui peut être comprise par exemple entre 5 nm et 100 nm, avantageusement entre 5 et 30 nm.

La couche isolante 11 peut être prévue quant à elle avec une épaisseur comprise par exemple entre 15 nm et 200 nm.

Un exemple de réalisation particulier prévoit une couche isolante 11 d'oxyde de silicium de 145 nm et une couche superficielle 12 et une couche de silicium de l'ordre de 23 nm ou 30 nm d'épaisseur.

Le support 100 sur lequel repose la couche isolante 11 est, dans cet exemple de réalisation particulier, une couche semi-conductrice 10 de support d'un substrat de type semi-conducteur sur isolant, par exemple de type SOI (SOI pour « Silicon On Insulator » ou « Silicium sur isolant »).

Le ou les transistors formé(s) peu(ven)t être prévu(s) en technologie FDSOI (pour "Fully Depleted Silicon On Insulator" ou « silicium sur isolant totalement déplété »).

Dans l'exemple de réalisation illustré, la structure est dotée d'un bloc 25 de grille de transistor. Ce bloc 25 est formé ici d'une région 21 de diélectrique de grille, par exemple en SiO₂ ou en HfO₂ surmontée d'une région 22 de grille formée d'une ou plusieurs couches de matériau de grille par exemple à base de polysilicium ou de TiN ou de W ou d'un empilement d'au moins plusieurs de ces matériaux. Des espaceurs 33 sont réalisés de part et d'autre du bloc 25 de grille. Ces espaceurs 33 peuvent être par exemple à base de SiN ou de SiBCN ou de SiOCN.

Des régions semi-conductrices 42 dites « surélevées », par exemple en silicium, sont ici formées de part et d'autre du bloc 25 de grille, typiquement par épitaxie.

Ensuite, on réalise une amorphisation des régions semi-conductrices 42 et des portions 12a de la couche semi-conductrice 12 superficielle. Cette amorphisation est typiquement mise en oeuvre au moyen d'au moins une implantation ionique.

Dans l'exemple illustré sur la figure 1B, une implantation d'amorphisation inclinée est réalisée. Ainsi, utilise un faisceau d'implantation réalisant un angle α non-nul par rapport à une normale n à un plan principal du support 100 (i.e. un plan du support parallèle au plan [O; x ;y] d'un repère orthogonal [O; x; y ; z] donné sur la figure 1B). On réalise ici de préférence la ou les implantations d'amorphisation après avoir formé des espaceurs isolants 33 de part et d'autre du bloc 25 de grille.

L'amorphisation est ici avantageusement effectuée sur toute l'épaisseur e (e = e₀+ e₁) des régions semi-conductrices 42 et de la couche semi-conductrice 12. Ainsi, les régions semi-conductrices 42 surélevées d'épaisseur e₁ sont entièrement rendues amorphes.

Les portions 12a de la couche semi-conductrice 12 superficielle e₀ sont également rendues amorphes sur toute leur épaisseur e₀ et atteignent ainsi la couche isolante 11 de sorte à être en contact avec cette dernière.

Du fait de l'implantation à faisceau incliné, les portions 12a rendues amorphes de la couche semi-conductrice superficielle peuvent comporter des zones 12c qui s'étendent sous les espaceurs 33.

Pour réaliser l'amorphisation, une implantation d'une espèce neutre et non dopante, par exemple des ions Silicium ou Germanium, avec des conditions de dose, d'énergie déterminées par simulation et vérification expérimentales par imagerie TEM (microscopie électronique en transmission) peut être mise en oeuvre. Des outils de simulations reposant sur une méthode de Monte-Carlo, en particulier de type TRIM (TRIM pour « TRansport of Ions in Matter », i.e. Transport d'ions dans la matière, et/ou KMC (pour « kinetic Monte Carlo », i.e. méthode de Monte-Carlo cinétique).

Par exemple, une implantation d'ions Ge avec une dose de 6×10¹⁴ ions*cm⁻² selon une énergie de 9 keV peut permettre d'obtenir une épaisseur amorphe de l'ordre de 15 nm de silicium.

Dans le cas notamment d'une amorphisation réalisée à l'aide d'une espèce neutre, on peut ensuite (figure 1C) réaliser un dopage des parties de la couche semi-conductrice 12 de part et d'autre du bloc 25 de grille et en particulier un dopage de zones d'extension situées de part et d'autre de la grille en regard des espaceurs isolants 33.

Ainsi, dans l'exemple de réalisation illustré sur la figure 1C, on effectue une implantation dopante à l'aide d'un faisceau incliné et réalisant un angle α' non-nul par rapport à une normale n à un plan principal du support 100 afin notamment de réaliser un dopage des portions 12a rendues amorphes et des zones 12c situées sous les espaceurs isolants 33.

Selon une possibilité de mise en oeuvre, cette implantation dopante peut être prévue à faible dose, c'est à-dire typiquement inférieure à 1.0×10¹⁴ ions*cm⁻² et avantageusement inférieure à 5.0×10¹³ ions*cm⁻².

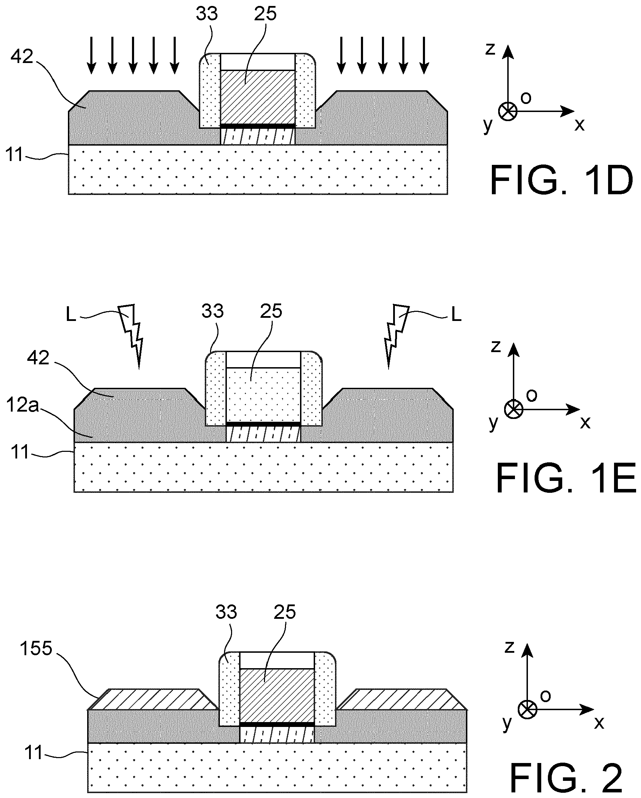

Ensuite, on peut effectuer une autre implantation dopante (figure 1D) cette fois à plus forte dose et à l'aide d'un faisceau droit c'est à dire parallèle ou sensiblement parallèle à une normale n à un plan principal du support 100. On effectue alors un dopage des régions 42 surélevées et rendues amorphes en particulier sur toute leur épaisseur.

Une décomposition du dopage en une implantation à faible dose et inclinée et en une autre implantation à plus forte dose et droite (i.e. parallèle à une normale au substrat) peut permettre d'éviter de réaliser un dopage trop près d'une zone 121 de la couche semi-conductrice dans laquelle le canal des transistors est prévu. On peut toutefois en variante prévoir de mutualiser ces deux étapes de dopage.

La ou les étapes de dopage sur des régions semi-conductrices 42 surélevées et des portions 12a rendues amorphes sur toute leur épaisseur favorise ici la réalisation d'un dopage des régions 42 et portions 12a sur toute leur épaisseur.

On effectue ensuite (figure 1E) un recuit laser L de sorte à réaliser une recristallisation des régions semi-conductrices 42 surélevées et des portions 12a de la couche semi-conductrice 12 superficielle.

Un traitement laser permet de chauffer à des températures élevées, très rapidement et un refroidissement rapide de la structure, une fois l'exposition au laser arrêtée. La recristallisation laser peut être en particulier mise en oeuvre en soumettant les régions 42 et les portions 12a à une voire à plusieurs impulsion(s) d'un faisceau laser L, et en particulier d'un laser dit « nano-seconde », c'est-à-dire avec une durée d'impulsion typiquement inférieure à 1 microseconde.

L'utilisation d'un laser fonctionnant en régime impulsionnel permet de limiter le budget thermique, tout en évitant une montée globale trop importante en température du reste de la structure.

La longueur d'onde du laser L, la durée d'impulsion du faisceau laser et de préférence la densité d'énergie du faisceau laser sont choisies en fonction notamment de l'épaisseur de la couche superficielle et des régions surélevées 42 ainsi que de la réflectivité des couches sous-jacentes.

De préférence, la durée d'impulsion et la densité d'énergie du laser sont choisies de sorte à effectuer une recristallisation dans un régime dit « de recristallisation explosive ». Un tel régime est décrit par exemple dans le document « Melting Temperature and Explosive Crystallization of Amorphous Silicon during Pulsed Laser Irradiation », Thompson et al., 1984. Le recuit thermique laser est en particulier prévu de sorte à transformer ces portions 12a et régions 42 en matériau polycristallin, en particulier en polysilicium lorsque ces portions 12a et régions 42 sont en silicium amorphe.

Typiquement, on prévoit d'utiliser un laser de longueur d'onde comprise entre 200 nm et 600 nm, et en particulier entre 200 nm et 400nm.

La durée de la, ou de chaque, impulsion du faisceau laser peut être comprise par exemple entre 1 ns et 1000 ns, et de préférence entre 10 ns et 500 ns.

A longueur d'onde donnée du laser, la densité d'énergie du faisceau laser choisie dépend de la réflectivité de l'empilement.

Selon un exemple de réalisation particulier avec une couche 12 de silicium de l'ordre de 12 nm et des régions 42 surélevées en silicium d'épaisseur maximale comprise entre 20 et 30 nm , on peut prévoir une densité d'énergie comprise entre 0.5 et 1.0 J/cm².

Cette gamme peut être élargie et/ou modifiée en fonction de l'empilement réalisé de la couche superficielle 12 et des régions 42 et des doses de dopants utilisées. L'Homme du Métier peut s'appuyer sur des outils de simulations par exemple tels que COMSOL Multiphysics ou LIAB (LASSE Innovation Application Booster) et d'outils de charactérisation physique à l'aide d'imagerie par exemple TEM (Microscopie électronique en transmission) et ellipsomètre pour déterminer les conditions précises en fonction de l'empilement choisi.

Les portions 12a et les régions 42 surélevées étant dopées, le traitement thermique par laser permet concomitamment de réaliser une activation de dopants.

La recristallisation en régime explosif avec un laser nano-seconde a pour avantage de pouvoir être mise en oeuvre, même lorsque les régions à recristalliser sont entièrement amorphe et que, comme dans l'exemple de réalisation décrit plus haut, on ne prévoit pas de couche cristalline sous-jacente pour servir de zone de départ à un front de recristallisation.

Outre les avantages précités, la mise en oeuvre d'une recristallisation avec un laser nano-seconde fonctionnant en régime impulsionnel favorise la conservation de la forme des régions semi-conductrices 42 surélevées.

Afin d'aider à préserver la forme des régions semi-conductrices 42 surélevées lors du recuit d'activation, on peut, selon une réalisation optionnelle particulière, prévoir préalablement à l'exposition au laser nano-seconde, de revêtir, ces régions d'une couche d'encapsulation transparente au rayonnement laser utilisé. Une telle couche d'encapsulation sert alors de moule et permet de préserver la forme des régions semi-conductrices 42 surélevées malgré une éventuelle fonte partielle d'une partie supérieure de ces régions.

Selon une possibilité de mise oeuvre, après la recristallisation des portions 12a et régions 42 surélevées, on peut ensuite former des zones 155 d'alliage de métal et de semi-conducteur dans les régions semi-conductrices surélevées 42 (figure 2).

Cette étape de préférence est réalisée à une température inférieure à 600°C et avantageusement inférieure à 500°C. Pour cela, on peut utiliser par exemple un procédé de pulvérisation (« sputtering » selon la terminologie anglo-saxonne) pour déposer un matériau métallique puis effectuer un traitement thermique. Un exemple particulier de procédé consiste, lorsque les régions surélevées 42 sont en silicium, à réaliser une siliciuration en formant des zones 155 d'un alliage métal-silicium par exemple du NiPtSi.

En variante de l'exemple de procédé décrit précédemment, on peut mutualiser des étapes d'amorphisation et de dopage en mettant en oeuvre une implantation d'amorphisation à l'aide d'une espèce dopante.

Par exemple, une implantation selon une énergie d'implantation adéquate et à l'arsenic ou au phosphore peut être mise en oeuvre pour réaliser un dopage de type N concomitamment à une amorphisation des régions 42 surélevées et de la couche semi-conductrice superficielle 12. Un autre exemple de réalisation prévoit une implantation de BF2 pour réaliser une amorphisation et un dopage concomitant de type P. Pour une implantation de phosphore les conditions suivantes peuvent être par exemple utilisées : dose =5^{E}14 at/cm². Energie = 10keV, pour réaliser une amorphisation d'environ 16 nm. Pour les doses et énergies d'implantation semblables, avec des ions BF2 une profondeur d'amorphisation de l'ordre de 11nm peut être obtenue.

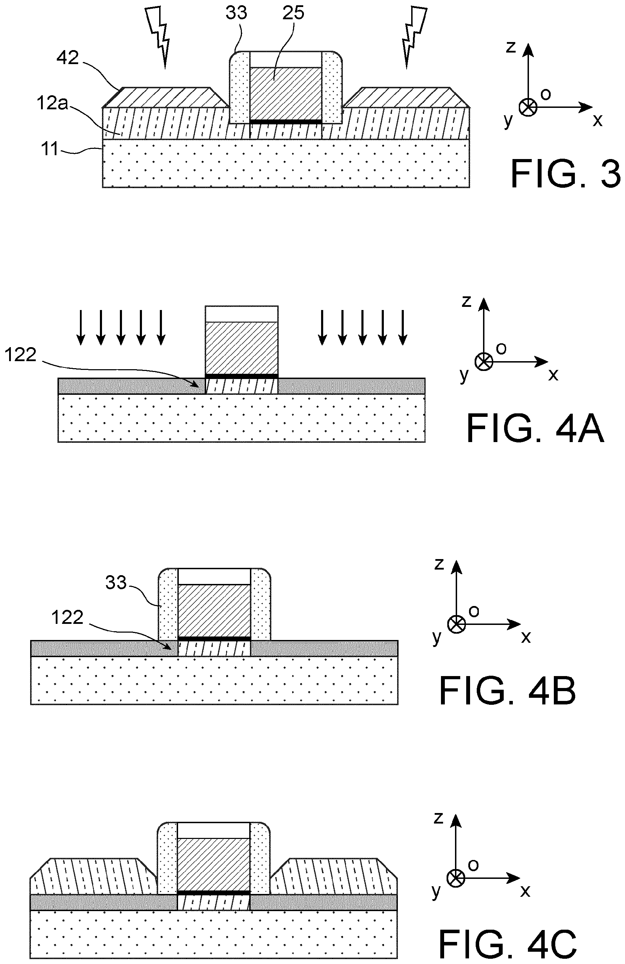

Selon une variante de réalisation illustrée sur la figure 3, un recuit laser tel que décrit précédemment et pour recristalliser les régions 42 et portions 12a peut être effectué après une étape de dépôt de métal en vue de former des zones 155 d'alliage de métal et semi-conducteur. Dans ce cas, on peut mutualiser au moins une partie du recuit de recristallisation et pour réaliser des zones d'alliage de métal et de semi-conducteur. Cela peut permettre également de former des zones d'alliage de métal et de semi-conducteur à partir d'un matériau sans défaut cristallin.

Selon une autre variante de réalisation, le dopage de la couche semi-conductrice superficielle 12 et des régions semi-conductrices surélevées peut être réalisé en plusieurs étapes.

On peut prévoir en particulier de doper les zones d'extension après formation du bloc 25 de grille mais préalablement à la réalisation d'espaceurs.

Ainsi, dans l'exemple de réalisation illustré sur la figure 4A, on effectue pour cela au moins une première implantation dopante de préférence avec un faisceau non incliné par rapport à une normale au plan principal du support.

Puis (figure 4B), on forme les espaceurs 33. Cela peut être réalisé par exemple par dépôt d'une couche isolante, par exemple en nitrure de silicium, puis gravure, par exemple une gravure sèche à l'aide d'un plasma. Avant de procéder à cette gravure on réalise typiquement une étape de photolithographie afin de protéger les zones que l'on ne souhaite pas graver.

On forme ensuite (figure 4C) de part et d'autre des espaceurs 33, les régions semi-conductrices 42 surélevées par épitaxie sur la couche semi-conductrice 12 superficielle.

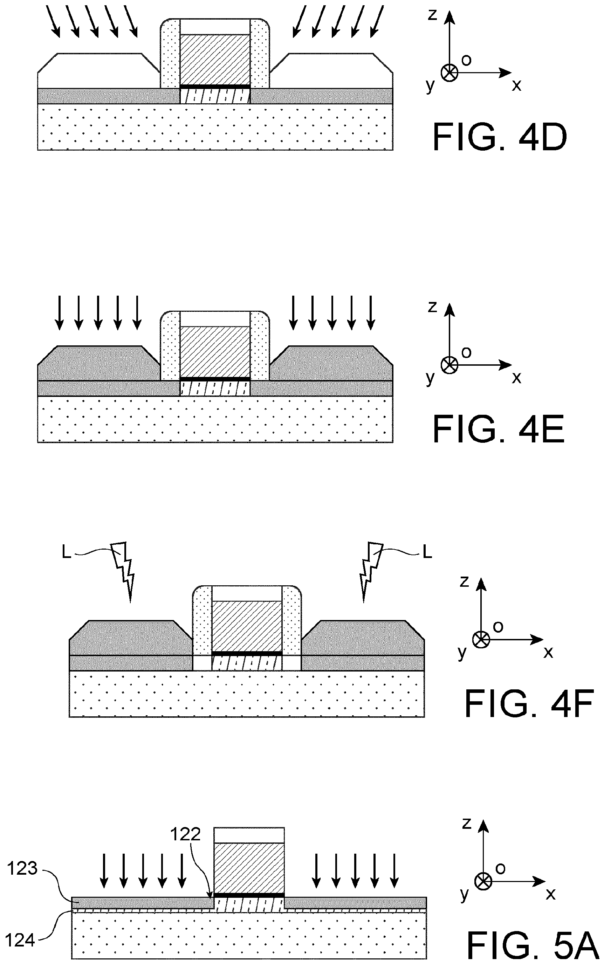

Puis, on effectue l'amorphisation (figure 4D) des régions 42 et des portions de la couche semi-conductrice 12a superficielle et on réalise ensuite (figure 4E) un dopage de ces régions 42. Ces étapes d'amorphisation et de dopage peuvent, là encore, être en variante mutualisées et effectuées en une seule implantation.

On réalise ensuite la recristallisation et l'activation de dopants par à un recuit laser L, en particulier un laser nanoseconde et de préférence en mettant en oeuvre le régime explosif de recristallisation tel que décrit précédemment (figure 4F).

Selon une autre variante de l'exemple de procédé décrit précédemment, on réalise la ou les implantations dopantes de la couche semi-conductrice superficielle 12 et visant à réaliser un dopage de zones d'extension 122 cette fois en dopant et rendant amorphe de manière concomitante une partie supérieure 123 de la couche semi-conductrice superficielle.

Dans ce cas, on préserve de préférence une zone inférieure 124 cristalline et non amorphisée de la couche semi-conductrice superficielle 12 sous cette partie supérieure 123 rendue amorphe et dopée. Dans l'exemple de réalisation particulier illustré sur la figure 5A, cette étape est effectuée avant de former des espaceurs.

La zone 124 cristalline préservée peut avoir une épaisseur e₁₂₄ comprise par exemple entre 2 et 10nm pour une couche semi-conductrice d'épaisseur comprise entre 5 et 30 nm.

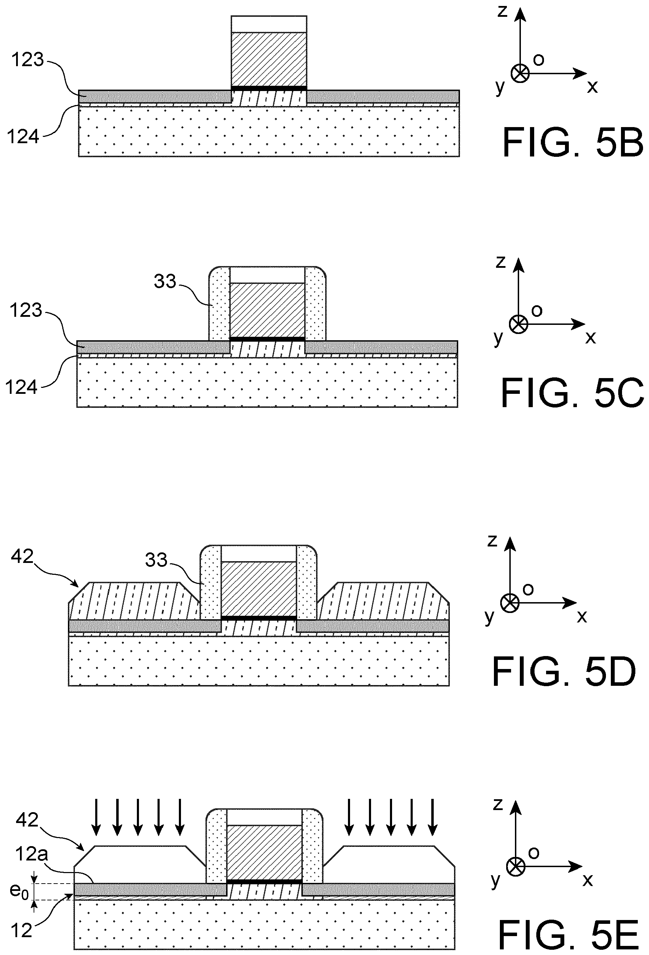

Une fois l'implantation des dopants effectuée, on réalise au moins un traitement thermique de sorte à effectuer un recuit de recristallisation de la partie supérieure 123 (figure 5B).

On se sert alors de la zone inférieure 124 comme zone de départ d'un front de recristallisation. Un procédé de croissance épitaxiale en phase solide (SPER pour « Solid Phase Epitaxial Regrowth ») du matériau semi-conducteur amorphe en contact avec le matériau semi-conducteur cristallin est en particulier effectué à une température de préférence inférieure à 500°C et qui peut être comprise par exemple entre 400°C et 500°C.

Puis (figure 5C), on forme les espaceurs 33, par exemple par dépôt d'une couche par exemple d'épaisseur comprise entre 1 et 10 nm de nitrure de silicium puis gravure.

Des régions semi-conductrices surélevées 42 (figure 5D) sont ensuite formées par épitaxie.

On réalise ensuite une amorphisation (figure 5E) complète par implantation de ces régions 42 et des portions 12a de la couche semi-conductrice 12 superficielle agencées de part et d'autre des espaceurs 33 et qui s'étendent sur toute l'épaisseur e0 de cette couche superficielle 12 jusqu'à atteindre la couche isolante 10 sous-jacente.

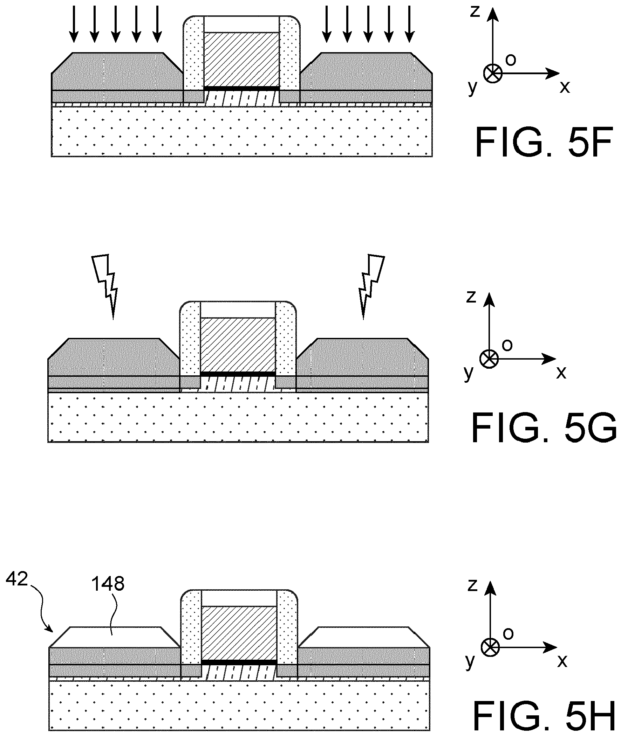

Ensuite (figure 5F), on peut effectuer une implantation dopante de sorte à réaliser un dopage de préférence sur toute l'épaisseur des régions 42 et des portions 12a de la couche semi-conductrice 12 superficielle.

Puis, on réalise une recristallisation et une activation de dopants par exposition à un laser L telle que décrite précédemment, en particulier à l'aide d'un laser nano-seconde et typiquement de manière à transformer en matériau polycristallin, en particulier du polysilicium, les régions 42 surélevées ainsi que les portions 12a de la couche semi-conductrice superficielle 12 (figure 5G).

Selon des étapes optionnelles, on peut ensuite réaliser à nouveau une amorphisation (figure 5H) cette fois d'une partie supérieure 148 des régions semi-conductrices 42 surélevées. Cette amorphisation est mise en oeuvre à l'aide d'une implantation qui peut être éventuellement mise en oeuvre à l'aide d'une espèce dopante.

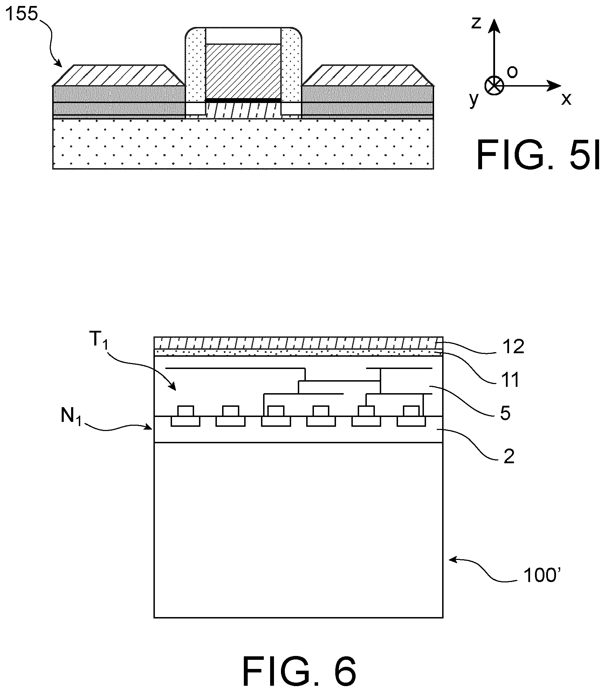

Puis (figure 5I), on forme des zones 155 d'alliage de métal et de semi-conducteur, en particulier dans la partie supérieure 148 des régions semi-conductrices 42 surélevées. On effectue pour cela un dépôt métallique, par exemple du Nickel ou un alliage de Nickel et de Platine puis un recuit, par exemple à une température comprise entre 200 et 400°C.

Selon une autre variante de réalisation, on peut prévoir de mettre en oeuvre un procédé tel que décrit précédemment sur un support différent du substrat décrit précédemment.

En particulier, la structure de départ du procédé peut être telle que dans l'exemple de réalisation particulier de la figure 6, où la couche semi-conductrice superficielle 12 et la couche isolante 11 reposent ici sur un support 100' comportant déjà un premier niveau N₁ de composants, par exemple de transistors.

Ainsi, un ou plusieurs transistors T₁ d'un premier niveau N₁ de composants sont, dans l'exemple de réalisation illustré, formés en partie dans une couche semi-conductrice 2 sous-jacente.

Les transistors T₁ du premier niveau N₁ sont recouverts d'un ou plusieurs étages d'interconnexions métalliques formés dans une ou plusieurs couches isolantes, typiquement un empilement 5 de couches isolantes, par exemple en SiO₂. L'empilement 5 de couches isolantes est doté ou revêtu de la couche isolante 11 de BOX, cette couche isolante 11 étant elle-même revêtue de la couche semi-conductrice superficielle 12.

Le procédé décrit précédemment peut alors être appliqué afin de réaliser un ou plusieurs transistors d'un deuxième niveau. Un recuit de d'activation et de recristallisation au laser nanoseconde tel que décrit précédemment et adapté en particulier pour réaliser une recristallisation en régime explosif comme évoquée plus haut est alors tout particulièrement adapté à ce type de structure. Il permet en particulier de réaliser un dopage des régions de source et de drain de transistors du deuxième niveau sans venir impacter et risquer de détériorer les composants du premier niveau.

## Revendications

1. Procédé pour la réalisation d'un transistor comprenant les étapes suivantes :
- prévoir sur un support (100, 100') doté d'une couche semi-conductrice superficielle (12) et reposant sur une couche isolante (11) : au moins un bloc de grille (25) de transistor agencé sur la couche superficielle (12), des espaceurs isolants (33) entourant ce bloc (25) de grille, et des régions semi-conductrices (42) dites surélevées reposant sur la couche semi-conductrice superficielle (12) de part et d'autre de ce bloc (25) de grille et des espaceurs isolants (33),
- rendre amorphe les régions semi-conductrices (42) surélevées et des portions (12a) de la couche semi-conductrice superficielle (12) situées sous ces régions semi-conductrices (42) surélevées sur toute l'épaisseur desdites régions semi-conductrices (42) surélevées et desdites portions (12a), de sorte à atteindre la couche isolante (11),
- doper les régions semi-conductrices (42) surélevées et lesdites portions (12a),
- effectuer au moins un recuit thermique laser au moyen d'une ou plusieurs impulsions laser (L) de sorte à réaliser une recristallisation desdites régions surélevées (42) et desdites portions (12a) tout en effectuant une activation de dopants dans lesdites régions et lesdites portions.

2. Procédé selon la revendication 1, dans lequel l'étape consistant à rendre amorphe lesdites régions semi-conductrices (42) surélevées et lesdites portions (12a) est effectuée par implantation à l'aide d'un faisceau incliné par rapport à une normale (n) à un plan principal du support, de sorte à réaliser une amorphisation de zones (12c) de la couche superficielle (23) qui s'étendent sous les espaceurs (33).

3. Procédé selon l'une des revendications 1 ou 2, dans lequel l'étape consistant à doper lesdites régions semi-conductrices (42) surélevées et lesdites portions (12a) comprend une implantation à l'aide d'un faisceau incliné par rapport à une normale à un plan principal du support, de sorte à doper des zones (12c) de la couche superficielle (23) qui s'étendent sous les espaceurs (33).

4. Procédé selon l'une des revendications 1 à 3, comprenant en outre des étapes de :
- formation du bloc (25) de grille,
- formation d'espaceurs (33) de part et d'autre du bloc (25) de grille,
- formation desdites régions (42) semi-conductrices surélevées de part et d'autre des espaceurs (33), le procédé comprenant en outre après formation du bloc de grille et préalablement à la formation des espaceurs :
- le dopage de zones (122) dites d'extension de la couche semi-conductrice superficielle situées de part et d'autre du bloc (25) de grille, les espaceurs étant formés en regard desdites zones d'extension (122).

5. Procédé selon la revendication 4, dans lequel le dopage des zones d'extension (122) dans la couche semi-conductrice superficielle (12) de part et d'autre du bloc (25) de grille comprend des étapes consistant à :
- rendre amorphe et doper une partie supérieure (123) de la couche superficielle (12) tout en conservant une zone inférieure (124) cristalline de la couche superficielle (12) en contact avec la couche isolante (11),
- effectuer un recuit de sorte à recristalliser ladite partie supérieure (123) de la couche superficielle (12).

6. Procédé selon la revendication 5, dans lequel après formation des espaceurs isolants (33) et préalablement à l'amorphisation desdites régions semi-conductrices (42) surélevées et portions (12a) de la couche semi-conductrice superficielle (12) situées sous ces régions semi-conductrices (42) :
- former par épitaxie les régions semi-conductrices surélevées (42) sur ladite partie supérieure (123) recristallisée de ladite couche superficielle (12).

7. Procédé selon l'une des revendications 1 à 6, dans lequel après recuit thermique laser on forme des régions (155) à base de composé de matériau métallique et de matériau semi-conducteur dans les régions semi-conductrices surélevées (42).

8. Procédé selon la revendication 7, dans lequel préalablement audit recuit thermique laser on dépose au moins une couche de matériau métallique de sorte à recouvrir les régions semi-conductrices surélevées (42), le recuit thermique laser étant adapté pour former les régions (155) à base de composé de matériau métallique et de matériau semi-conducteur dans les régions semi-conductrices surélevées (42).

9. Procédé selon la revendication 7, dans lequel après ledit recuit thermique laser, le procédé comprend des étapes consistant à :
- rendre amorphe des parties supérieures (148) desdites régions semi-conductrices surélevées (42), puis
- déposer au moins une couche de matériau métallique de sorte à recouvrir lesdites régions semi-conductrices surélevées (42) et effectuer un recuit pour former des régions (155) à base de composé de matériau métallique et de matériau semi-conducteur dans lesdites parties supérieures (148).

10. Procédé selon l'une des revendications 1 à 9, dans lequel l'étape de recuit thermique laser est effectuée à l'aide d'un laser par émission d'une ou de plusieurs impulsions laser successives, de durée d'impulsion inférieure à une microseconde et de préférence comprise entre 1 ns et1000 ns, avantageusement entre 20 ns et 300 ns, le laser ayant une longueur d'onde comprise entre 200 nm et 600 nm et avantageusement entre 200 et 400nm.

11. Procédé selon l'une des revendications 1 à 10, dans lequel le recuit thermique laser est effectué de sorte à recristalliser lesdites régions semi-conductrices surélevées (42) et lesdites portions (12a) de la couche semi-conductrice superficielle (12) rendues amorphes dans un régime de recristallisation dans lequel les régions semi-conductrices surélevées (42) et lesdites portions (12a) sont transformées en matériau polycristallin.

12. Procédé selon l'une des revendications 1 à 11, dans lequel le support (100) est un substrat de type semi-conducteur sur isolant tel qu'un substrat SOI ou un support doté d'un ou plusieurs composants d'un premier niveau (N1) de composants formés dans une couche semi-conductrice (2) sous-jacente.

13. Procédé selon l'une des revendications 1 à 12, lesdites portions (12a) de la couche semi-conductrice superficielle (12) situées sous ces régions semi-conductrices (42) surélevées correspondant à des parties de la couche semi-conductrice superficielle non recouvertes par le bloc de grille et s'étendant sur toute l'épaisseur de la couche semi-conductrice superficielle (12).

14. Procédé selon l'une des revendications 1 à 13, l'étape consistant à rendre amorphe les régions semi-conductrices (42) surélevées et les portions (12a) de la couche semi-conductrice superficielle (12) étant effectuée de sorte à ne conserver aucun germe cristallin dans la couche superficielle en dehors d'une zone en regard du bloc de grille.
